# EUROPEAN PATENT SPECIFICATION

(11) **EP 2 775 812 B1**
(45) Date of publication and mention of the grant of the patent: **21.11.2018**
(21) Application number: 12846552.3
(22) Date of filing: 10.10.2012
(51) Int. Cl.: H05K 13/02, H05K 13/04

(54) **TAPE FEEDER**
BANDZUFÜHRUNG
SYSTÈME D'AVANCEMENT DE BANDE

(30) Priority: 01.11.2011 JP 2011240360
(43) Date of publication of application: 10.09.2014
(73) Proprietor: FUJI Corporation, Chiryu Aichi (JP)
(72) Inventor: TAKADA, Yukinori, Chiryu-shi Aichi 472-8686 (JP)
(74) Representative: Grünecker Patent- und Rechtsanwälte PartG mbB
(86) International application number: PCT/JP2012/076182
(87) International publication number: WO 2013/065459

(56) References cited:
- JP-A- 2002 533 944
- JP-A- 2005 203 524
- JP-A- 2006 156 514
- JP-A- 2007 073 632
- JP-A- 2010 507 908
- JP-A- 2011 029 297
- JP-A- 2011 138 834

## Description

### TECHNICAL FIELD

The present invention relates to a tape feeder with an improved configuration for setting component supply tape in which multiple electronic components are arranged at a specific pitch.

### BACKGROUND TECHNOLOGY

Conventional tape feeders, as disclosed in Prior Art 1 (Japanese Unexamined Patent Application Publication Number 2010-109109), index electronic component supply tape to a component pickup position by rotating a sprocket, the teeth of which are engaged with sprocket holes which are arranged at a specific pitch along the edge of component supply tape, such that components in the component supply tape can be picked up by a suction nozzle of an electronic component mounter at a component pickup position.

The work of setting component supply tape on this type of tape feeder comprises removing the tape feeder from the electronic component mounter, setting the reel of the component supply tape on the tape feeder, and engaging the sprocket holes of the component supply tape pulled out from the reel with the sprocket teeth.

### PRIOR ART REFERENCES

### PRIOR ART

Prior Art 1: Japanese Unexamined Patent Application Publication Number 2010-109109

The document JP 2011-029297 A discloses an electronic component feeder comprising a tape feed mechanism for feeding a component containing tape. Said tape feed mechanism includes a conveying sprocket and a driven sprocket. The electronic component feeder is capable of restricting the rotation of the driven sprocket by moving the driven sprocket the tooth tip of which does not mesh with a sprocket hole in the component containing tape to bring the driven sprocket into abutment on a rotation restricting part.

From JP 2007-073632 A a tape feeder is known which is so configured that a tape containing components may be fed to a component extractor by rotating a sprocket by means of a feed motor. The sprocket is formed with a plurality of tracks with magnetized portions having different patterns as absolute position information for identifying the absolute position of the sprocket in the rotating direction. By detecting the magnetized portions of the tracks by a magnetic sensor, the position of the sprocket in the rotating direction can be determined. At the time of feeding the tape, the feed motor is drive-controlled based on the output of the magnetic sensor.

JP 2011-138834 A discloses an electronic circuit component supplying apparatus comprising a plurality of tape feeders are held by a feeder holding apparatus, in a state where the component supplying sections of the tape feeders are arranged in a plurality of rows along a plurality of straight lines extending in parallel to each other on one plane.

### BRIEF SUMMARY OF THE INVENTION

### PROBLEM SOLVED BY INVENTION

With the above conventional tape feeders, when operators set component supply tape on a tape feeder, the work of engaging the sprocket holes of the component supply tape pulled out from the reel onto the teeth of the sprocket was troublesome.

With respect to this, for the problem to be solved by this invention, what is proposed is a tape feeder which can automate the work of engaging the teeth of the sprocket with the sprocket holes of the component supply tape.

### MEANS OF SOLVING THE PROBLEM

This object is solved by the features of claim 1. Further embodiments are laid down in the sub-claims. The present invention, for a tape feeder which indexes component supply tape to a component pickup position by rotating a sprocket while engaging the teeth of the sprocket in the sprocket holes which are formed along the edge of the component supply tape in which multiple electronic components are arranged at a specific pitch, is configured such that it is equipped with: a raising and lowering mechanism for moving the sprocket up and down between an engagement position in which the teeth of the sprocket are engaged with the sprocket holes of the component supply tape and a retract position in which the teeth of the sprocket are at a position lower than the sprocket holes of the component supply tape; and a control means for controlling the operation of the raising and lowering mechanism so that the sprocket is raised to the engagement position after the component supply tape has been set above the sprocket after the sprocket has been lowered to the retract position while the component supply tape is set on the tape feeder; and an engagement detection means for outputting a detection signal when the sprocket has been raised to the engagement position with the teeth of the sprocket engaged in the sprocket holes of the component supply tape when the sprocket is raised to the engagement position by the raising and lowering mechanism. By using this configuration, the work of engaging the teeth of the sprocket with the holes of the component supply tape can be automated.

In this case, using the control means, even when no detection signal is outputted from the engagement detection means because the teeth of the sprocket are not engaged with the sprocket holes of the component supply tape though controlling the raising of the sprocket to the engagement position by the raising and lowering mechanism was performed, it is desirable to perform automatic engagement operation to rotate the sprocket until the teeth of the sprocket are engaged with the sprocket holes of the component supply tape and the detection signal is outputted from the engagement detection means.

By doing this, whenever component supply tape is set on the tape feeder, even when performing control to raise the sprocket to the engagement position after lowering the sprocket to the retract position and setting component supply tape above the sprocket, if the teeth of the sprocket do not engage with the sprocket holes of the component supply tape and a detection signal is not outputted from the detection means, automatic engagement operation to rotate the sprocket is performed until the sprocket is rotated so that the teeth of the sprocket engage with the sprocket holes of the component supply tape and the engagement detection means outputs a detection signal; this means that at the same time as automating the work for engaging the teeth of the sprocket with the sprocket holes of the component supply tape, it is possible to ensure correct engagement of the teeth of the sprocket with the sprocket holes of the component supply tape using the automatic engagement operation.

Specifically, it is desirable for the raising and lowering mechanism to be equipped with a biasing means for biasing in the up direction the sprocket moving mechanism with the sprocket attached and an actuator for opposing and lowering the sprocket moving mechanism against the biasing means; and for the control means to be configured such that when component supply tape is set in the tape feeder, the sprocket is lowered to the retract position by lowering the sprocket moving mechanism against the biasing means using the actuator and, after the component supply tape is set above the sprocket, the sprocket is raised to the engagement position by raising the sprocket moving mechanism using the biasing means. With respect to the above, for the biasing means it is desirable to use items such as a spring or elastic material, and for the actuator to use items such as a motor or solenoid. If the sprocket moving mechanism, is biased up using the biasing means, when the teeth of the sprocket align with the sprocket holes of the component supply tape by rotating the sprocket during automatic engagement operation, the teeth of the sprocket will become engaged with the sprocket holes because the sprocket moving mechanism will be pushed by the biasing means.

In this case, it is acceptable for the rotation direction of the sprocket during automatic engagement operation to be forward or reverse rotation, but if during automatic engagement operation the teeth of the sprocket are not engaged with the sprocket holes of the component supply tape, because the teeth of the sprocket are rotated while contacting the lower surface of the component supply tape and the component supply tape moves shifted in the same direction as the sprocket, if the sprocket is only rotated in the forward direction during automatic engagement operation, unwanted movement past the component pickup position (where pickup is not possible with the suction nozzle) for the first component in the component supply tape may occur.

Therefore, when automatic engagement is performed, it is desirable after first rotating the sprocket in the reverse direction, engaging the teeth of the sprocket with the sprocket holes in the component supply tape and outputting a detection signal from the detection means, to rotate the sprocket in the forward direction to decide the position of the component supply tape. In this way, if automatic engagement operation is performed by rotating the sprocket in the reverse direction, it is possible to prevent the first component in the component supply tape moving past the component pickup position during automatic engagement operation, and it is possible to decide the position for the component pickup position of the first component in the component supply tape after confirming that the teeth of the sprocket are engaged with the sprocket holes of the component supply tape. For the present invention, it is acceptable to perform the work of setting component supply tape on the tape feeder with the tape feeder removed from the electronic component mounter, but because a raising and lowering mechanism for raising and lowering the sprocket is provided, it is possible to have a configuration in which the component supply tape can be set on the tape feeder while the tape feeder is attached to the electronic component mounter.

Specifically, it is desirable to have a configuration of a feeder main body equipped with a sprocket, raising and lowering mechanism, control means; and a tape supplier which supplies component tape pulled out from a tape reel to a component pickup point; with the tape reel and tape supplier removably attached to the feeder main body. With this configuration, when changing the component supply tapes, with the feeder main body left attached to the electronic component mounter, after removing the tape reel and tape supplier from the feeder main body, with the component supply tape pulled out from a new tape reel set and held in the tape supplier, if these are loaded onto the feeder main body, the teeth of the sprocket can be automatically engaged with the sprocket holes of the component supply tape during automatic engagement operation.

In this case, it is desirable to have a configuration in which the feeder main body is equipped with multiple each of sprockets, raising and lower mechanisms, and engagement detection means; for multiple tape suppliers to each be independently removably attached to the feeder main body; and for the teeth of each sprocket to be able to engage with the sprocket holes of the component supply tape supplied to each tape supplier. By doing this, it is possible to change to a new component supply tape by removing only the component supply tape which has run out of parts together with the tape supplier from the feeder main body from among the multiple component supply tapes set on the feeder main body which is attached to the feeder loading table of the electronic component mounter.

### BRIEF DESCRIPTION OF THE DRAWINGS

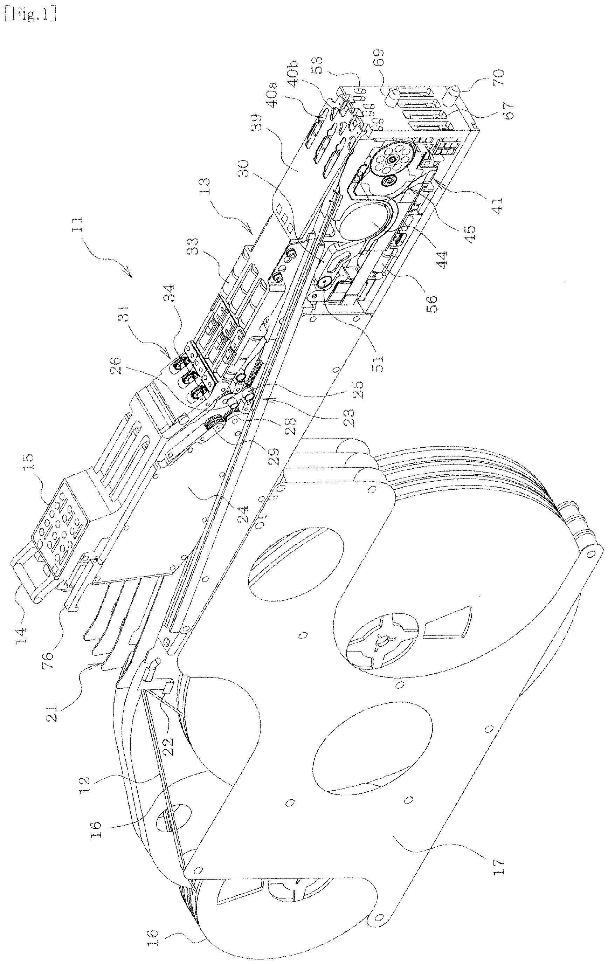

[FIG. 1] FIG. 1 is a perspective view showing the entire tape feeder from an embodiment of the present invention.
[FIG. 2] FIG. 2 is a perspective view of the feeder main body (1).

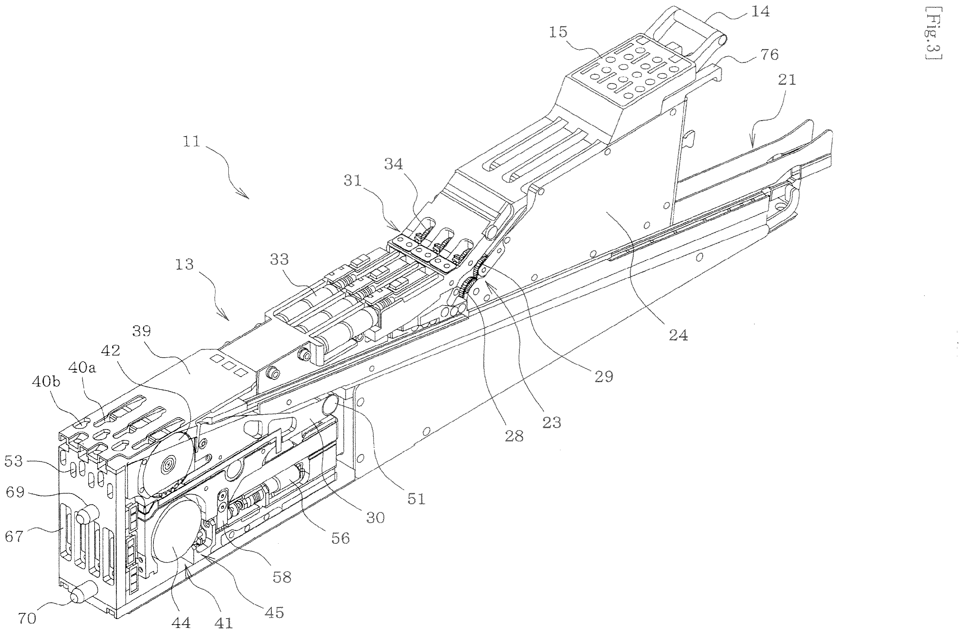

[FIG. 3] FIG. 3 is a perspective view of the feeder main body (2).
[FIG. 4] FIG. 4 is a perspective view of a tape supplier.
[FIG. 5] FIG. 5 is a perspective view showing the cover tape indexing gear moving device and surrounding section (1).
[FIG. 6] FIG. 6 is a perspective view showing the cover tape indexing gear moving device and surrounding section (2).
[FIG. 7] FIG. 7 is a perspective view of the end section of the feeder main body.
[FIG. 8] FIG. 8 is a perspective view showing the end section of the feeder main body with the end cover plate removed.
[FIG. 9] FIG. 9 is a perspective view of two sprocket moving units (1).
[FIG. 10] FIG. 10 is a perspective view of two sprocket moving units (2).

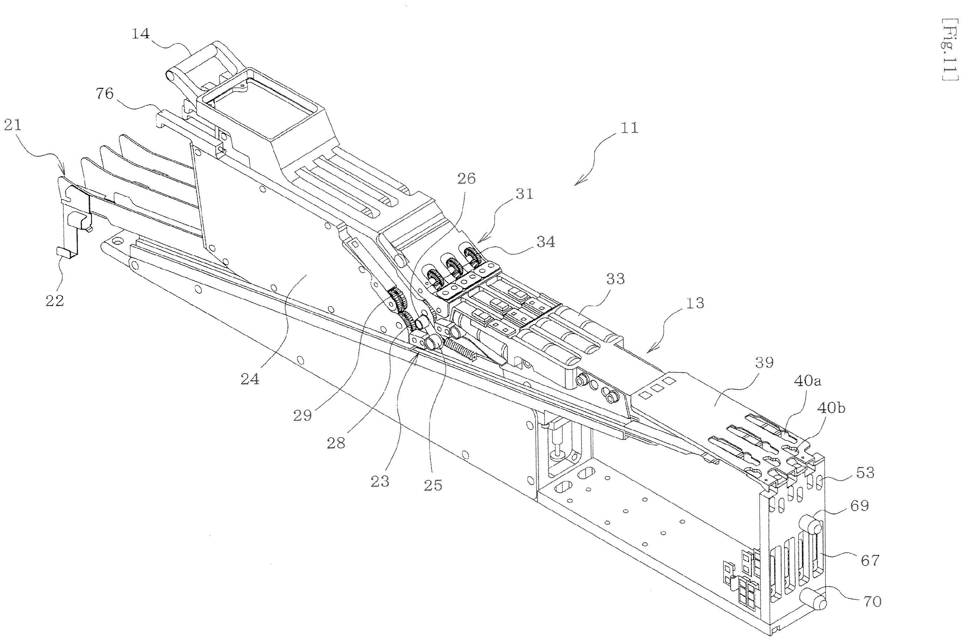

[FIG. 11] FIG. 11 is a perspective view showing the feeder main body with the sprocket moving units removed.
[FIG. 12] FIG. 12 is a perspective view showing the attachment configuration of the sprocket moving units to the feeder main body.

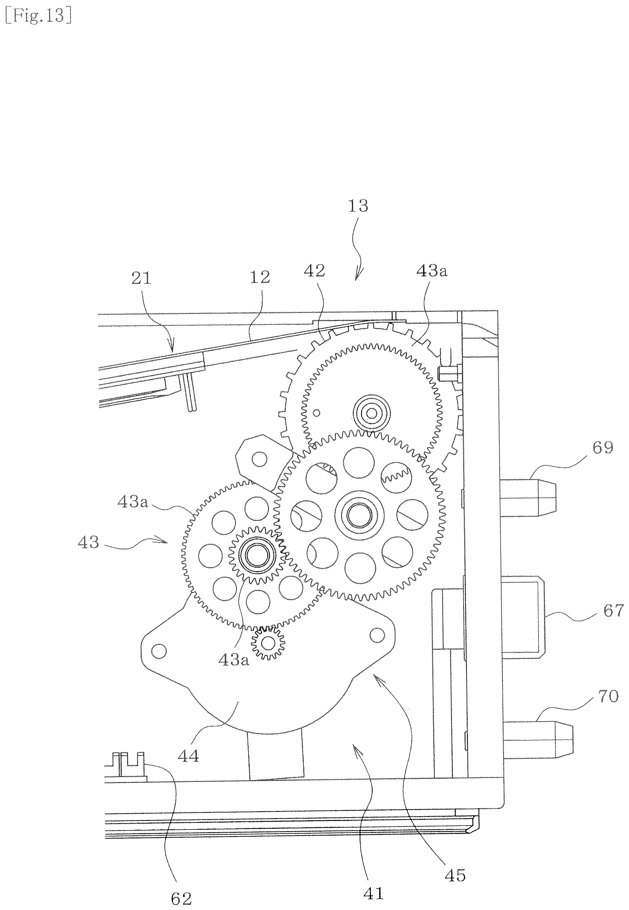

[FIG. 13] FIG. 13 is a right side view showing the configuration of the device for moving the sprocket.
[FIG. 14] FIG. 14 is a left side view showing the configuration of the device for moving the sprocket.
[FIG. 15] FIG. 15 is an enlarged cross-section view showing the configuration for supporting each cog of the spur gear set with bearings.
[FIG. 16] FIG. 16 is a perspective view of the feeder loading table of the electronic component mounter.
[FIG. 17] FIG. 17 is a perspective view showing the configuration of the underside of the operation panel of the feeder main body.
[FIG. 18] FIG. 18 is an enlarged perspective view of the tape supplier handle and the surrounding sections.
[FIG. 19] FIG. 19 is a block diagram showing the configuration of the tape feeder control items.
[FIG. 20] FIG. 20 is a flowchart showing the flow of processing of the automatic engagement operation control program.

### MODE FOR CARRYING OUT THE INVENTION

The following uses figures to describe a specific embodiment used to carry out the present invention. First, the configuration of tape feeder 11 is described.

Tape feeder 11 is constructed so that feeder main body 13 has a width that is an approximate multiple of the width of a standard tape feeder (a tape feeder on which only 1 component supply tape can be set), so that multiple component supply tape 12 can be set widthwise next to each other. In this embodiment, by making the gap between adjacent component supply tapes 12 small, the width of feeder main body 13 is about 4 times (about M times), for example, the width of a standard tape feeder, which means the configuration is such that 6 (N, where N is an integer large than M) component supply tapes 12 can be set widthwise next to each other. The figures do not show the details, but component supply tape 12 has carrier tape with components stored in component storage cavities formed in a line at a given pitch, top tape (also known as cover tape) attached to the upper surface of the carrier tape, and sprocket holes (not shown) formed in a line at a given pitch along the edge of component supply tape 12.

The upper section of the rear side (the removal side) of feeder main body 13 is equipped with handle 14 and operation panel 15, and the underside is equipped with reel holder 17 for storing tape reel 16 on which component supply tape 12 is wound. Reel holder 17 is formed such that multiple tape reels 16 can be arranged in 2 rows front and back, and each tape reel 16 is stored so that it can be rotated within reel holder 17 based on the unwinding of component supply tape 12. Operation panel 15 is equipped with items such as operation keys for inputting each type of operation signal such as the tape supplier attachment work start signal to each sprocket moving unit 41 (each tape supplier 21) which is described below.

Each component supply tape 12 unwound from tape reel 16 is supplied to the component pickup position by tape supplier 21. Each tape supplier 21 is configured such that it is removably attached to feeder main body 13, and so that only 1 of each component supply tape 12 can be set on each tape supplier 21, and the width of each tape supplier 21 is slightly larger than the width of component supply tape 12.

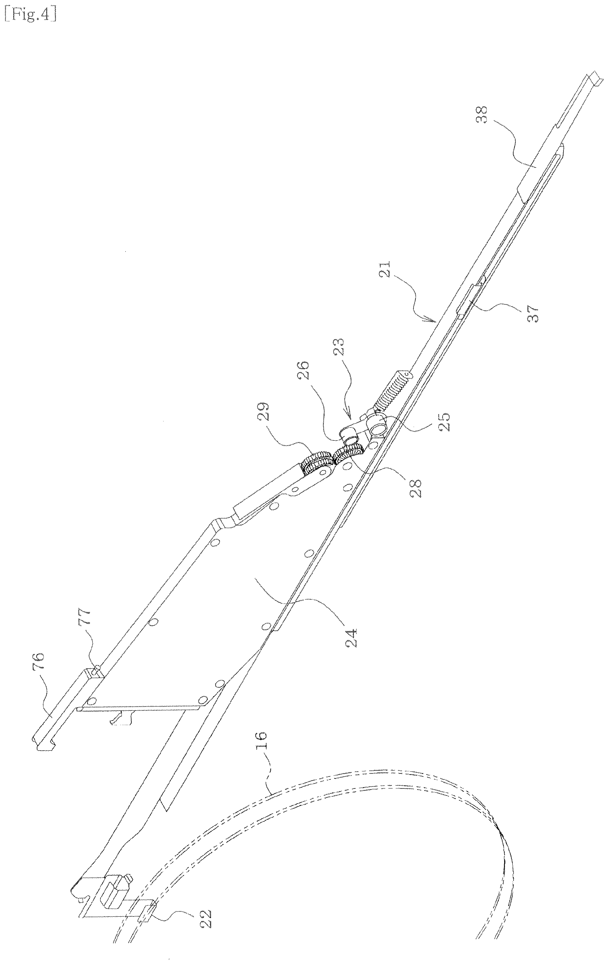

As shown in FIG. 4, the rear end of each tape supplier 21 is equipped with a reel hook 22 for holding tape reel 16 when tape supplier 21 is removed from feeder main body 13, and tape reel 16 can be held on reel hook 22.

Tape supplier 21 is equipped with cover tape peeling device 23 for peeling away the cover tape which covers the upper surface of component supply tape 12, and cover tape collection case 24 for collecting cover tape peeled from component supply tape 12. Cover tape peeling device 23 comprises peeling roller 25, tension roller 26, a pair of cover tape indexing gears 28 and 29, such that cover tape peeled with peeling roller 25 is fed to tension roller 26, then between cover tape indexing gears 28 and 29, and then fed into cover tape collection case 24.

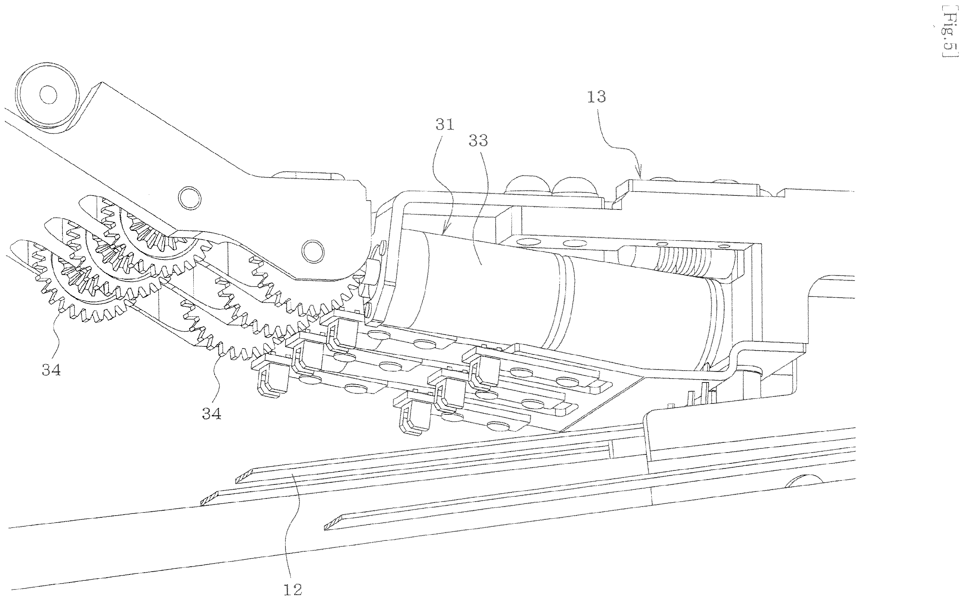

The moving power for cover tape indexing gears 28 and 29 is set on feeder main body 13, and when tape supplier 21 is attached to feeder main body 13, one of the cover tape indexing gears 28 engages with moving gear 34 (refer to FIG. 5) on feeder main body so that both cover tape indexing gears 28 and 29 are rotated.

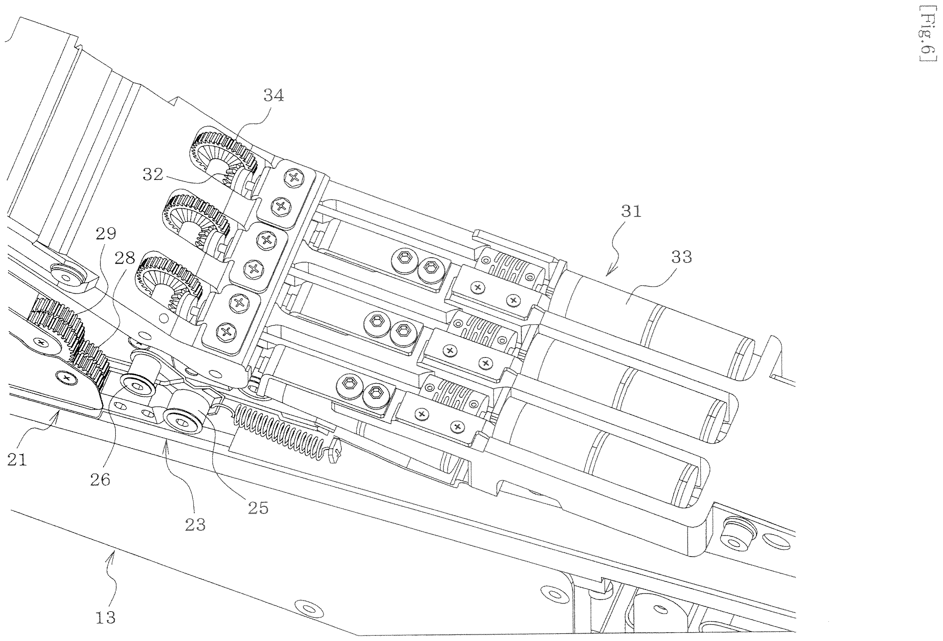

Moving device 31 for moving cover tape indexing gears 28 and 29 is set in the space above where tape supplier 21 is attached to feeder main body 13. This moving device 31 is equipped with motor 33 for rotating bevel gear 32 (refer to FIG. 6) and moving gear 34 which is rotated by bevel gear 32, with this moving gear 34 engaging with one of the cover tape indexing gears 28, by which both cover tape indexing gears 28 and 29 are rotated. The same number of each of motor 33, bevel gear 32, and moving gear 34 are equipped as the number of tape suppliers 21 which can be attached to feeder main body 13; with the amount that the cover tape is indexed (the amount peeled off) being able to be controlled independently for each tape supplier 21.

As shown in FIG. 4, on tape supplier 21, multiple C-shaped tape retainers 37 and 38 which support component supply tape 12 from one side only are arranged so that one supports component supply tape 12 from one side while the other supports it from the other side in an alternating zig-zag pattern; this slightly contorts component supply tape 12 widthwise (or tilts it diagonally) while supporting it, with each tape retainer 37 and 38 arranged slightly offset within the width of component supply tape 12, meaning that the component supply tape 12 can be supported within a narrower width.

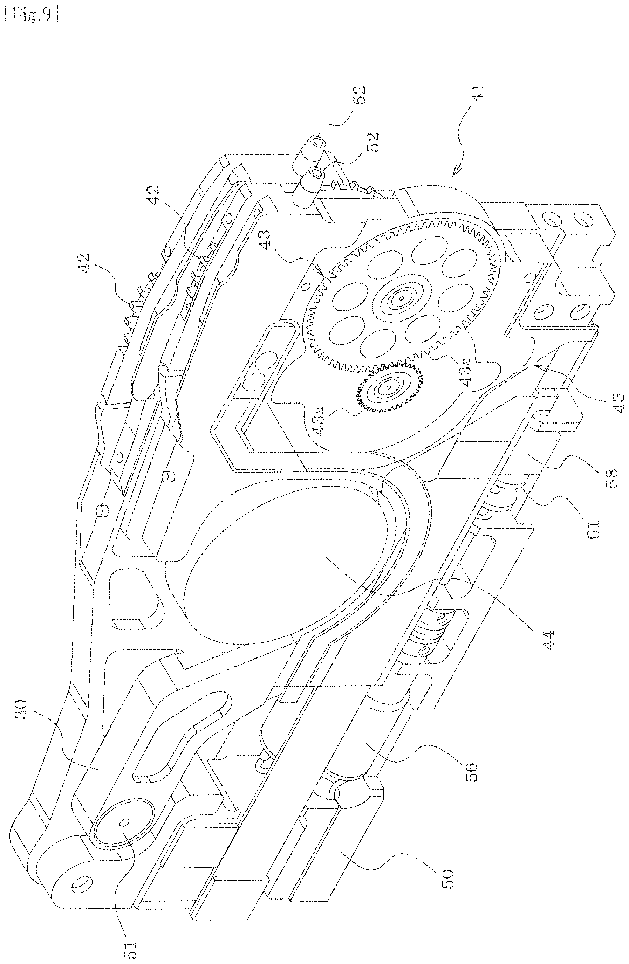

On the end of feeder main body 13, the same number of sprocket moving motors 41 as the number of component supply tapes 12 which can be set on the feeder main body 13 are attached next to each other widthwise. As described below, sprocket moving mechanism 45 of each sprocket moving unit 41 is configured with items such as sprocket 42 and motor 44 for moving sprocket 42 via spur gear set 43 (gear mechanism) attached to raising and lowering lever 30 (refer to FIGS. 9, 10 and 12), with these raised and lowered as one body around axis 51 as a fulcrum. Each sprocket 42 is arranged on feeder body 13 in an appropriate position for each set component supply tape 12, with pitch indexing of component supply tape 12 towards the component pickup position performed by rotating sprocket 42 with the teeth of sprocket 42 engaged in the sprocket holes of each component supply tape 12.

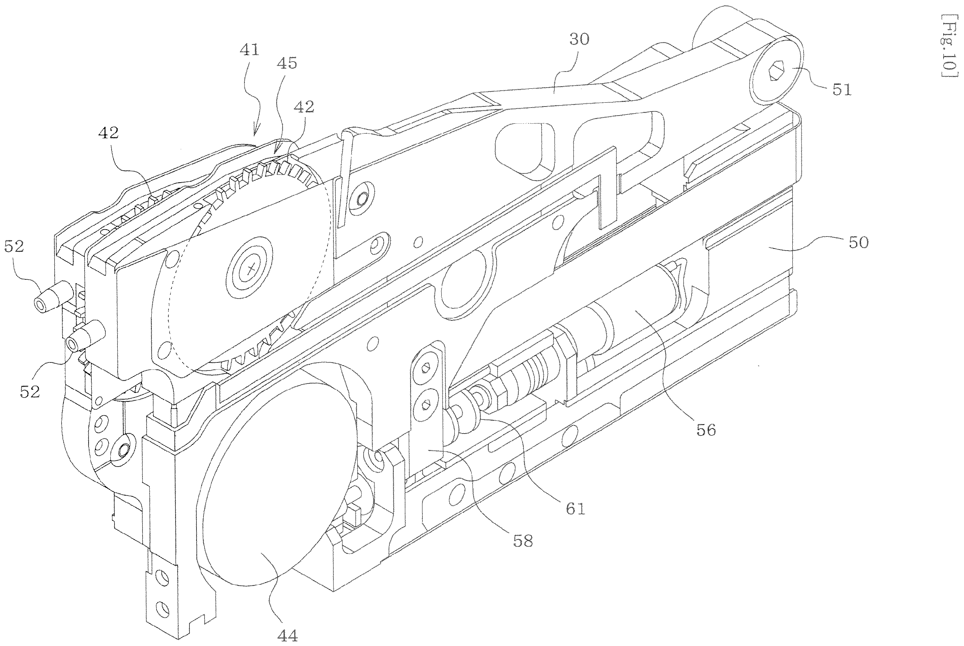

In order to make the width of each sprocket moving unit 41 smaller, as shown in FIGS. 9 and 10, sprocket position 42 of two adjacent sprocket moving units 41 are arranged offset forward/backward from each other, and each cog 43a of spur gear set 43 of two adjacent sprocket moving units 41 are arranged in an offset position, so that the open space of each sprocket moving unit 41 can be used effectively by creating space into which cog 43a of an adjacent sprocket moving unit 41 can protrude.

Sprocket moving mechanism 45 of each sprocket moving unit 41 uses a flat motor (such as a DC servo motor or pulse motor) as motor 44 for moving sprocket 42, with the rotating axis of motor 44 and the axis of sprocket 42 arranged in parallel so that the moving power of motor 44 is transmitted to sprocket 42 by spur gear set 43. By using this configuration, backlash adjustment is easy, countermeasures for thrust load are unnecessary, as well as the benefit of reduced costs due to the processing of parts being easy.

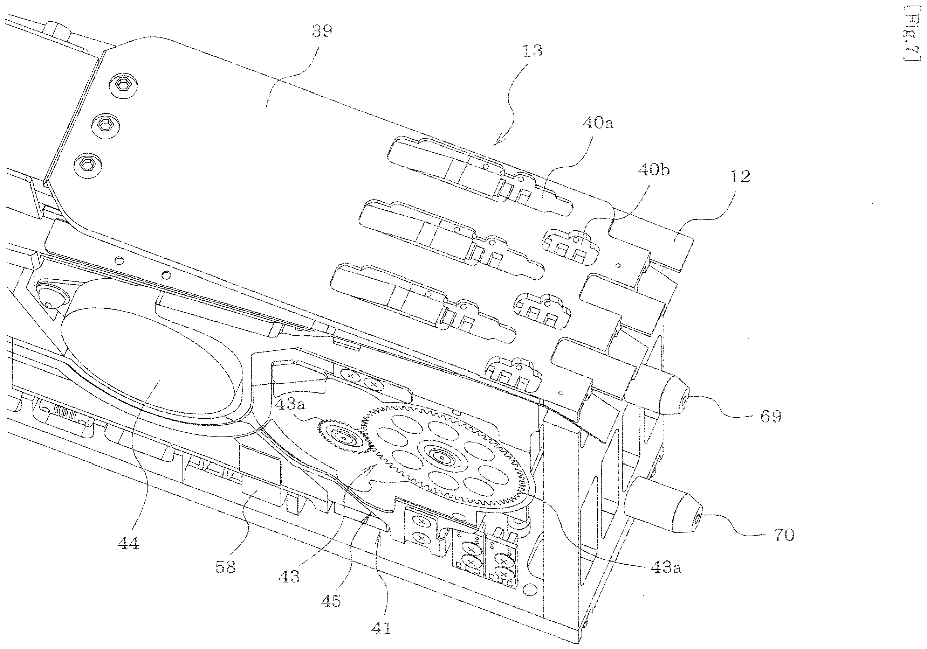

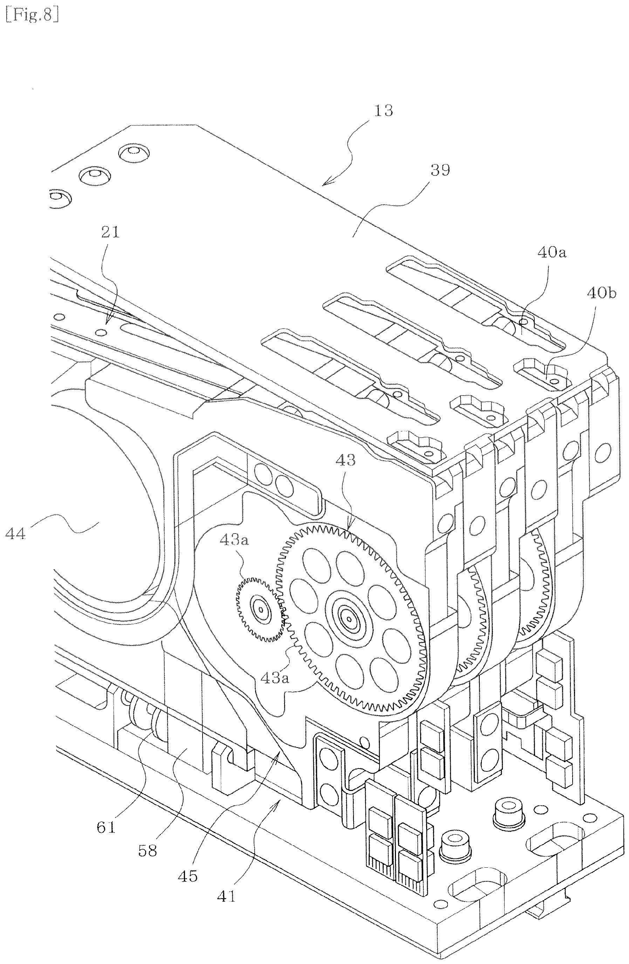

As shown in FIGS. 7 and 8, on top cover plate 39 which covers above sprocket moving units 41 within feeder body 13, component pickup openings 40a and 40b are arranged in a zig-zag pattern as openings for component pickup positions at which components in component supply tape 12 are picked up by suction nozzles of an electronic component mounter. In this embodiment, a total of 6 component supply tapes 12 can be attached to feeder body 13, so there are a total of 6 component pickup openings 40a and 40b.

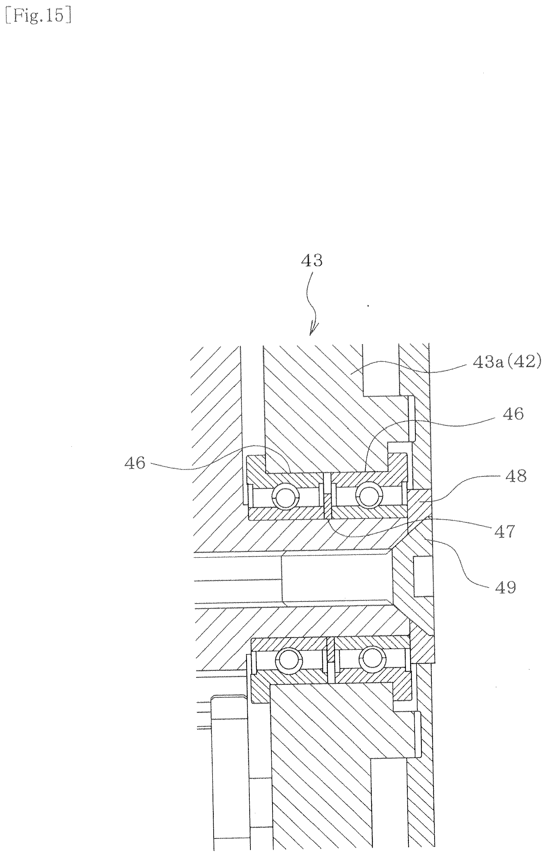

As shown in FIG. 15, as well as both each cog 43a of spur gear set 43 and sprocket 42 being supported for free rotation by 2 bearings 46, between the 2 bearings 46 elastic material 47 such as rubber or spring washer are introduced, with bearing retainer 48, used to stop the inner side of bearings 46 falling out, secured with screw 49 to compress elastic material 47, this configuration applying the appropriate precompression to bearings 46. This configuration means that the rotational transmission of each cog 43a of spur gear set 43 and sprocket 42 can be smoother, as well as being able to protect against a deterioration in rotational accuracy due to vibration and movement of cogs 43a.

Next, the following describes the configuration of the raising and lowering mechanism for independently raising and lowering each of the sprocket moving mechanism 45 of each sprocket moving unit 41.

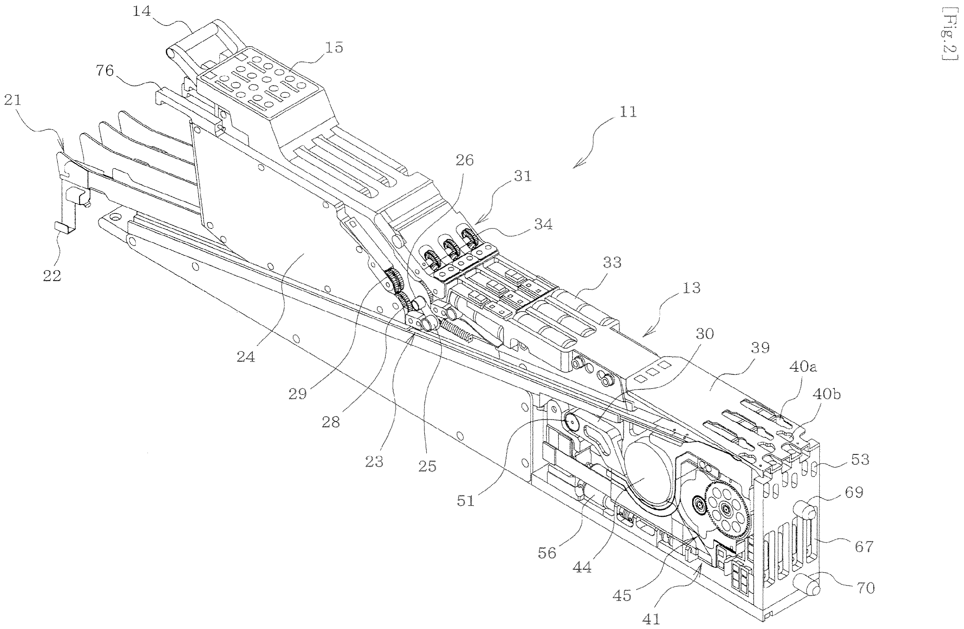

As shown in FIGS. 9, 10, and 12, raising and lowering lever 30 assembled to sprocket moving mechanism 45 of each sprocket moving unit 41 is assembled such that it can raise and lower sprocket 42 side around axis 51 as a fulcrum on unit base 50, with the configuration being such that raising and lowering is performed between an engagement position at which the teeth of sprocket 42 are engaged with the sprocket holes of component supply tape 12 and a retract position at which the teeth of sprocket 42 are a position lower than the sprocket holes of component supply tape 12. On the end surface of each sprocket moving unit 41, guide pins 52 for guiding the up and down movement are attached, and by engaging each guide pin 52 with each guide hole 53 (refer to FIG. 2) formed in the end surface of feeder main body 13, the range of possible up and down movement of each sprocket moving mechanism 45 is the range between the engagement position and retract position.

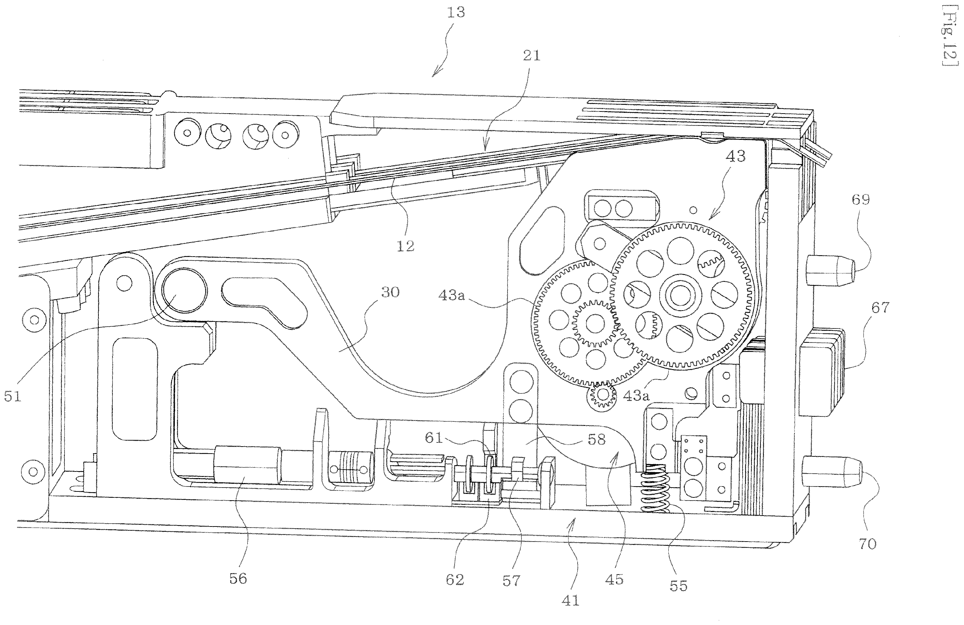

As shown in FIG. 12, each sprocket moving unit 41 is equipped with spring 55 used as a biasing means for biasing in the up direction the sprocket 42 side of sprocket moving mechanism 45 using axis 51 as a fulcrum, so that sprocket moving mechanism 45 can be kept in the upper position which is the engagement position by the elastic force of this spring 55. Each sprocket moving unit 41 is equipped with motor 56 acting as an actuator for opposing spring 55 and lowering sprocket moving mechanism 45.

Cams 57 are fixed to the rotating axis of each motor 56, and for these, on each sprocket moving mechanism 45, cam contacting material 58 such as in an L-shape to contact each cam 57 from below such is provided, and if motor 56 is rotated so that cam 57 rotates to the lowest point (or a point close to it), cam contacting material 58 and sprocket moving mechanism 45 oppose spring 55 as one body and are lowered and sprocket moving mechanism is kept in the retract position which is the lowest position. Then, if motor 56 is rotated to the original position and cam 57 is returned to the highest position (or a point close to it), sprocket moving mechanism 45 is pushed up and kept at the engagement position, which is the highest position, by the elastic force of spring 55 which follows the movement of cam 57. In this case, if electricity to motor 56 is turned off so that moving power to motor 56 is canceled, it is also acceptable to push up sprocket moving mechanism 45 by the elastic force of spring 55.

The rotating axis of each motor 56 is equipped with position detection dog 61 for detecting the position of each cam 57, and for these, each sprocket moving unit 41 is equipped with cam position sensor 62 (a light sensor such as a photo-interrupter, non-contact sensor such as a magnetic sensor) for detecting each position detection dog 61, so that each cam position sensor 62 can be used to detect which position it is in, the engagement position (highest) or the retract position (lowest).

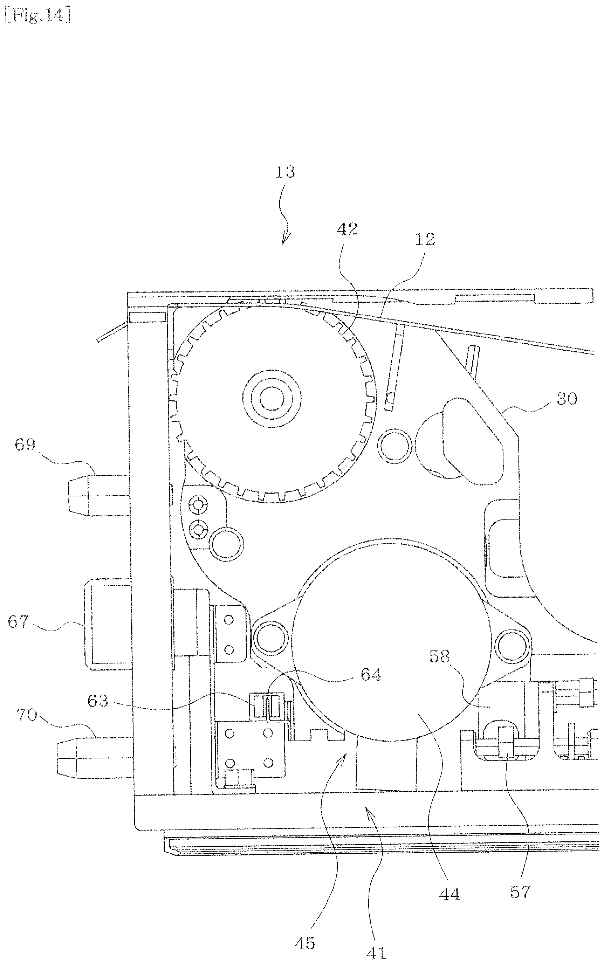

Also, as shown in FIG. 14, each sprocket moving unit 41 is equipped with engagement detection sensor 63 (a light sensor such as a photo-interrupter, non-contact sensor such as a magnetic sensor) as an engagement detecting means for detecting movement of sprocket 42 of sprocket moving mechanism 45 up to the engagement position. Each sprocket moving mechanism 45 is equipped with position detection dog 64 for detecting each engagement position, and if sprocket 42 is raised to the engagement position so that any of the sprocket teeth 42 of sprocket moving mechanism 45 are engaged in sprocket holes of component supply tape 12, with a configuration such that a detection signal is outputted as position detection dog 64 of sprocket moving mechanism 45 is detected by engagement detecting sensor 63.

In this case, the length of the teeth of sprocket 42 and positions of engagement detection sensor 63 and position detection dog 64 are set so that: when the teeth of sprocket 42 are engaged in the sprocket holes of component supply tape 12 which has the maximum thickness which can be set on tape feeder 11, engagement detecting sensor 63 detects position detection dog 64; and when the teeth of sprocket 42 are not engaged in the sprocket holes of component supply tape 12 which has the minimum thickness which can be set on tape feeder 11, engagement detecting sensor 63 does not detect position detection dog 64.

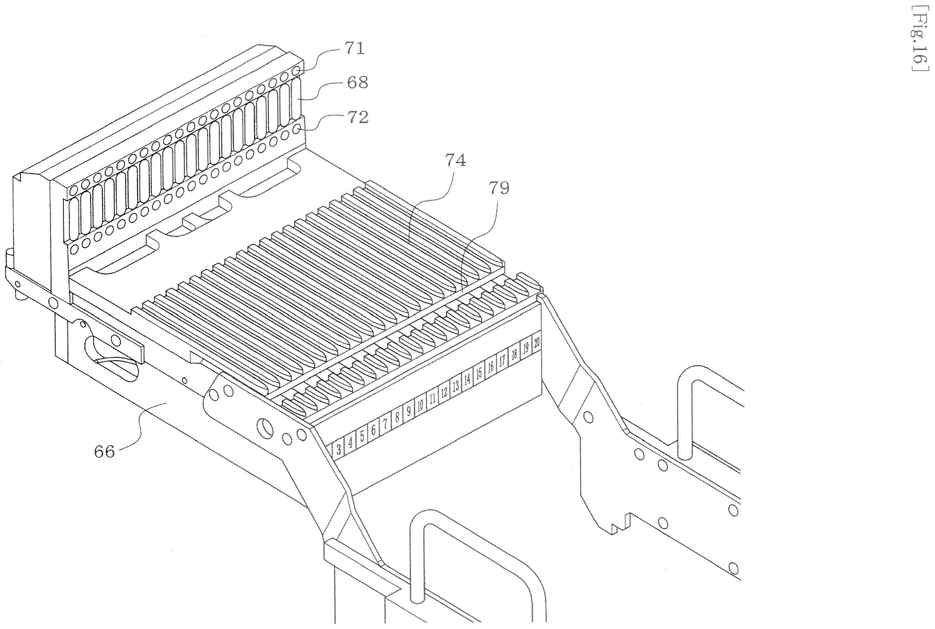

The front end of feeder main body 13 is equipped with connector 67 for connecting the signal wire and power wire of feeder main body 13 to connector 68 (refer to FIG. 16) of feeder loading table 66 of the electronic component mounter and 2 positioning pins 69 and 70; by inserting the 2 positioning pins 69 and 70 into positioning holes 71 and 72 (refer to FIG. 16) of feeder loading table 66 of the electronic component mounter, the attached position of feeder main body 13 on feeder loading table 66 can be decided, and connector 67 of feeder main body 13 is inserted into connector 68 of feeder loading table 66 so they are connected.

In order to support tape feeder 11 in an upright position, the upper surface of feeder loading table 66 is equipped with a guide groove which is a cross-section T-shaped groove, so that when the cross-section T-shaped guide rail (not shown) on the underside of feeder main body 13 is inserted into guide groove 74 from the front end, tape feeder 11 is supported in an upright position on feeder loading table 66; and by the clamping section (not shown) equipped on feeder main body 13 engaging with clamping groove 79 on feeder loading table 66 and pushing feeder main body 13 forward (towards connector 68 of feeder loading table 66) and clamping, the forward/back position of feeder main body 13 on feeder loading table 66 is decided and the feeder can be attached and removed.

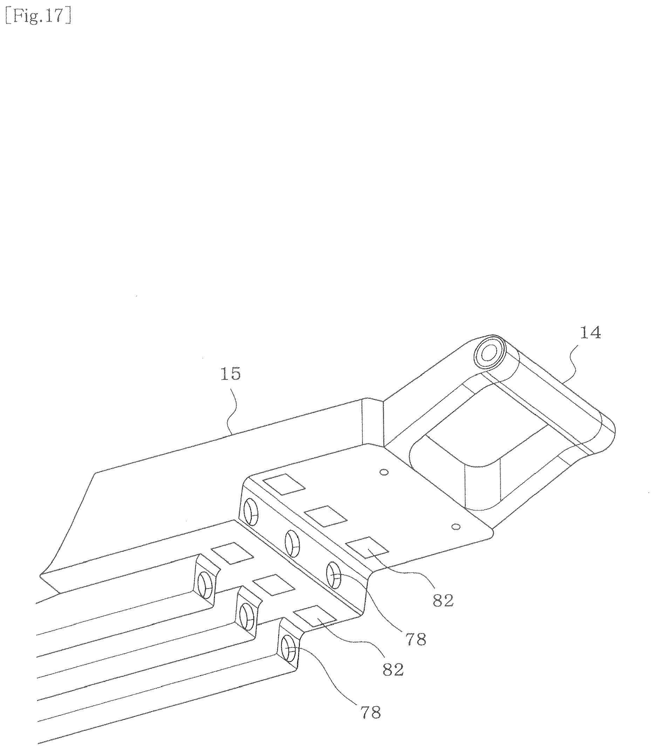

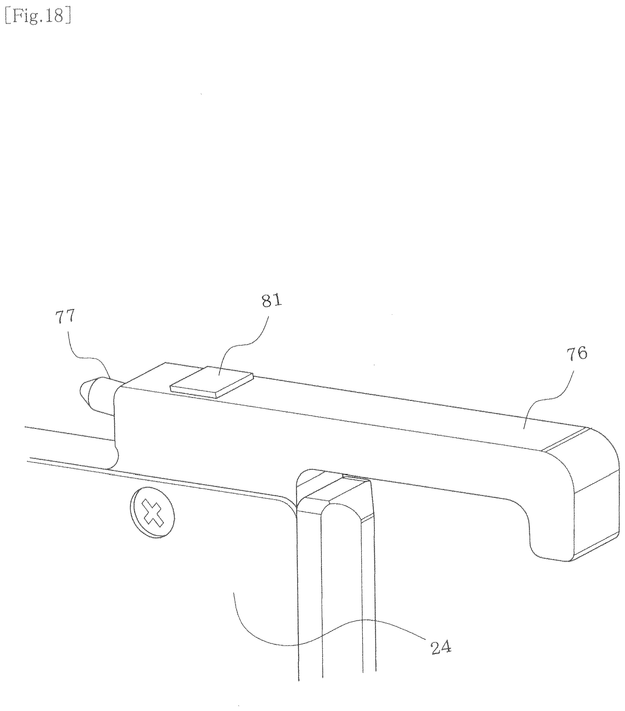

The upper end section of cover tape collection case 24 of each tape supplier 21 is equipped with handle 76, with each handle 76 being equipped with positioning pin 77 (refer to FIG. 18) on the front end. For these, on the lower stepped section of operation panel 15 of feeder main body 13 there are positioning holes 78 (refer to FIG. 17), and when tape supplier 21 is set on feeder main body 13 positioning pin 77 of handle 76 is inserted into positioning hole 78 on the underside of operation panel 15 so that the position of handle 76 is decided with respect to the underside of operation panel 15.

As shown in FIG. 18, RF tag 81 (also known as an electronic tag, IC tag, electromagnetic tag, wireless tag) with tape supplier 21 identification information (hereafter referred to as "supplier ID") memorized is attached to the upper surface of handle 76.

It is also acceptable for information such as component information of component supply tape 12 to be memorized on RF tag 81 as well as the supplier ID, or instead of the supplier ID.

For this, the underside of operation panel 15 of feeder main body 13 is equipped with reader 82 (refer to FIG. 17) for reading the supplier ID memorized in RF tag 81, so that when tape supplier 21 is set on feeder main body 13 and positioning pin 77 of handle 76 is inserted into positioning hole 78 on the underside of operation panel 15, RF tag 81 on the upper surface of handle 76 comes adjacent and opposite to reader 82 on the underside of operation panel 15, and the supplier ID memorized on RF tag 81 is read by reader 82.

The supplier ID signal outputted by this reader 82 is also used as the set confirmation signal of tape supplier 21 onto feeder main body 13, so that the setting of tape supplier 21 onto feeder main body 13 is confirmed by reading the supplier ID with reader 82. For the reader 82 arranged on the underside of operation panel 15, at least the antenna of reader 82 should be arranged; but it is acceptable for the control circuit section of reader 82 to be separated from the antenna and arranged on another section.

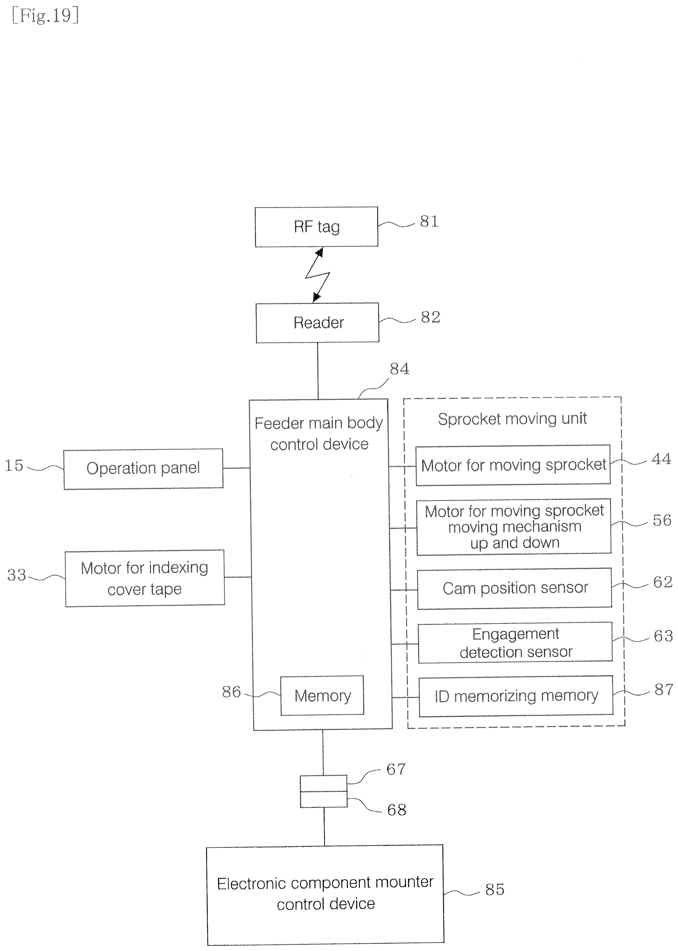

On the other hand, as shown in FIG. 19, feeder main body 13 is equipped with control device 84 (control means) for operating items such as each motor 33, 44, and 56; and the supplier ID read by reader 82 is sent to control device 84, and then sent from control device 84 to control device 85 of the electronic component mounter via connectors 67 and 68. Feeder main body 13 identification information (hereafter referred to as "feeder main body ID") is memorized in memory 86 (feeder main body identification information memorizing means) of control device 84 of feeder main body 13, and this feeder main body ID is also sent from control device 84 to control device 85 of the electronic component mounter via connectors 67 and 68.

Furthermore, each sprocket moving unit 41 is also equipped with ID memorizing memory 87 which memorizes the identification information of sprocket moving unit 41 (hereafter referred to as "the sprocket moving unit ID"), and control device 84 of feeder main body 13 reads the sprocket moving unit ID memorized in memory 87 for memorizing the ID of each sprocket moving unit 41 and sends it to control device 85 of the electronic component mounter. By this, control device 85 of electronic component mounter can manage individually tape suppliers 21, feeder main bodies 13, and sprocket moving units 41 by using the supplier ID, feeder main body ID, and sprocket moving unit ID.

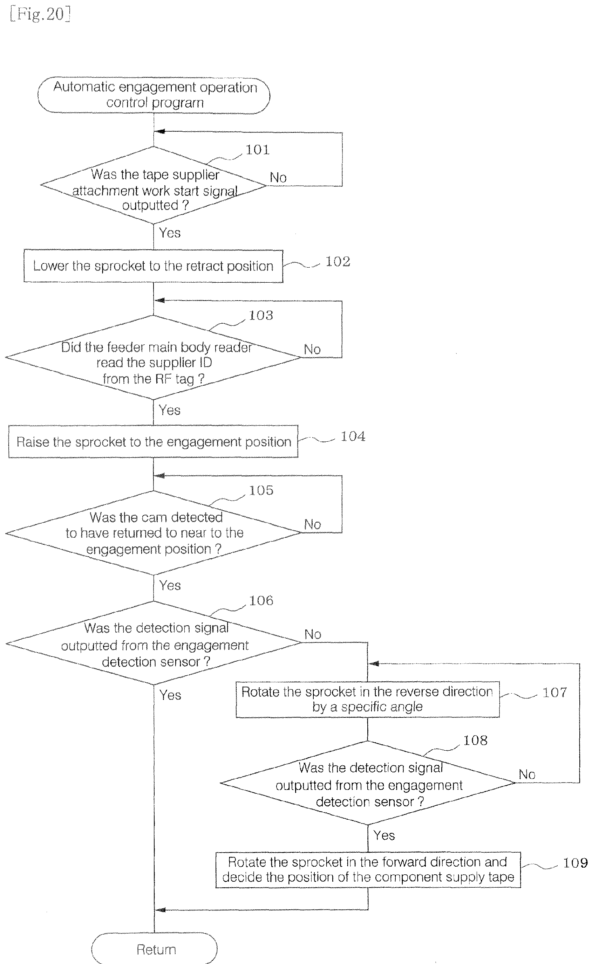

For control device 84 of feeder main body 13, by running the automatic engagement operation control program from FIG. 20 below, when tape supplier 21 is set on feeder main body 13, after sprocket 42 is automatically lowered to the retract position and component supply tape 12 is set above sprocket 42, motor 56 for moving the sprocket moving mechanism up and down is controlled so that sprocket 42 is raised to the engagement position; if control is performed to raise sprocket 42 to the engagement position but the teeth of sprocket 42 do not engage with the sprocket holes of component supply tape 12 and a detection signal is not output from engagement detection sensor 63, rotation of sprocket 42 via automatic engagement operation is performed whereby sprocket 42 is rotated by motor 44 until the teeth of sprocket 42 engage with the sprocket holes of component supply tape 12 and a detection signal is outputted by engagement detection sensor 63.

Below describes the internal processing of the automatic engagement operation control program from FIG. 20 which is run by control device 84 of feeder main body 13. The automatic engagement operation control program from FIG. 20 is run repeatedly for each sprocket moving unit 41 (each tape supplier 21) while electric power is supplied to control device 84 of feeder main body 13.

When this program is started, first, in step 101, a judgment is performed as to whether a tape supplier work start signal has been inputted (whether the operator pressed the attachment work start key on operation panel 15); if a tape supplier work start signal has been not been inputted yet, the program waits until a tape supplier work start signal is inputted.

After that, when a tape supplier work start signal is inputted, internal processing from step 102 onwards of the automatic engagement operation control program is run as follows. First, in step 102, motor 56 for moving the sprocket moving mechanism up and down is operated and sprocket moving mechanism 45 is lowered in opposition to spring 55, until sprocket 42 is lowered until the retract position.

After that, continuing to step 103, from whether reader 82 of feeder main body 13 reads the supplier ID from RF tag 81 of tape supplier 21, the program judges whether the operator has completed the work of attaching tape supplier 21 to feeder main body 13 (whether RF tag 81 of tape supplier 21 was placed in front of reader 82 of feeder main body 13); if reader 82 of feeder main body 13 has not read the supplier ID yet, the program waits until the supplier ID is read.

After that, when reader 82 of feeder main body 13 has read the supplier ID from RF tag 81 of tape supplier 21, the program judges that the operator has completed the work of attaching tape supplier 21 to feeder main body 13 and, continuing to step 104, by rotating motor 56 for raising and lowering the sprocket moving mechanism to its original position and returning cam 57 to the highest position (or a point close to it), after raising sprocket moving mechanism 45 to the engagement position by the elastic force of spring 55 which follows the movement of cam 57, turn the power to motor 56 off. In this case, if electricity to motor 56 for raising and lowering the sprocket moving mechanism is turned off so that moving power to motor 56 is canceled, it is also acceptable to raise sprocket moving mechanism 45 to the engagement position by the elastic force of spring 55. After that, continuing to step 105, the program judges whether cam position sensor 62 detected that cam 57 returned to near the engagement position (highest position); if cam 57 has not returned to the near the engagement position (highest position), the program waits until cam 57 returns to the engagement position (highest position). Alternatively, it is also acceptable to judge whether the specific time required for sprocket 42 to rise to the engagement position has elapsed; and if the specific time has not elapsed yet, to wait until the specific time has elapsed.

After that, when cam position sensor 62 detects that cam 57 has returned to near the engagement position (highest position) (or when the specific time has elapsed), continuing to step 106, by judging whether a detection signal has been outputted from engagement detection sensor 63, the program judges whether the teeth of sprocket 42 are engaged in the sprocket holes of component supply tape 12; and if a detection signal has been outputted from engagement detection sensor 63 it is judged that the teeth of sprocket 42 are engaged in the sprocket holes of component supply tape 12 and automatic engagement operation is completed. In this case, it is also desirable to rotate sprocket 42 an appropriate amount to decide the position of the first component in component supply tape 12 with respect to the component supply position.

With respect to this, in step 106 above, if it is judged that a detection signal has not been outputted from engagement detection sensor 63, the program judges that the teeth of sprocket 42 are not yet engaged with the sprocket holes of component supply tape 12 and, continuing to step 107, after rotating motor 44 in the reverse direction to rotate sprocket 42 in the reverse direction by a specific angle, continuing to step 108, the program judges whether a detection signal has been outputted from engagement detection sensor 63; if a detection signal has not been outputted yet, the program judges the teeth of sprocket 42 are not engaged with the sprocket holes of component supply tape 12 and the program returns to step 107 and repeats the processing of rotating motor 44 in the reverse direction to rotate sprocket 42 in the reverse direction by a specific angle. By this, processing is repeated to rotate sprocket 42 by a specific angle each time in the reverse direction using motor 44 until a detection signal is outputted from engagement detection sensor 63, and when a detection signal is output from engagement detection sensor 63, the program judges that the teeth of sprocket 42 are engaged in the sprocket holes of component supply tape 12 and, continuing to step 109, motor 44 is rotated forwards to rotate sprocket 42 forwards to decide the position of the first component in component supply tape 12 with respect to the component supply position and automatic engagement operation is completed.

According to the present embodiment described above, when tape supplier 21 is set on feeder main body 13, even when performing control to raise sprocket 42 to the engagement position after lowering sprocket 42 to the retract position and setting component supply tape 12 above sprocket 42, if the teeth of sprocket 42 do not engage with the sprocket holes of component supply tape 12 and a detection signal is not outputted from engagement detection sensor 63, automatic engagement operation to rotate sprocket 42 is performed until sprocket 42 is rotated so that the teeth of sprocket 42 engage with the sprocket holes of component supply tape 12 and engagement detection sensor 63 outputs a detection signal; this means that at the same time as automating the work for engaging the teeth of sprocket 42 with the sprocket holes of component supply tape 12, it is possible to ensure correct engagement of the teeth of sprocket 42 with the sprocket holes of component supply tape 12 using the automatic engagement operation.

In this case, it is acceptable for the rotation direction of sprocket 42 during automatic engagement operation to be forward or reverse rotation, but if during automatic engagement operation the teeth of sprocket 42 are not engaged with the sprocket holes of component supply tape 12, because the teeth of sprocket 42 are rotated while contacting the lower surface of component supply tape 12 and component supply tape 12 moves shifted in the same direction as sprocket 42, if sprocket 42 is only rotated in the forward direction during automatic engagement operation, unwanted movement past the component pickup position (where pickup is not possible with the suction nozzle) for the first component in component supply tape 12 may occur.

Therefore, in the present embodiment, when automatic engagement operation is performed, because sprocket 42 is rotated in the forward direction to decide the position of component supply tape 12 after first rotating sprocket 42 in the reverse direction so the teeth of sprocket 42 engage with the sprocket holes of component supply tape 12 and a detection signal is outputted from engagement detection sensor 63, it is possible to prevent the first component in component supply tape 12 moving past the component pickup position during automatic engagement operation, and it is possible to decide the position for the component pickup position of the first component in component supply tape 12 after confirming that the teeth of sprocket 42 are engaged with the sprocket holes of component supply tape 12.

In addition, in the present embodiment, because the configuration is such that tape reel 16 and tape supplier 21 are removably attached to feeder main body 13, when changing component supply tape 12, with feeder main body 13 left attached to the electronic component mounter, after removing tape reel 16 and tape supplier 21 from feeder main body 13, with component supply tape pulled out from a new tape reel 16 set and held in tape supplier 21, if these are loaded onto feeder main body 13, the teeth of sprocket 42 can be automatically engaged with the sprocket holes of component supply tape 12 by the automatic engagement operation, and the changeover work for component supply tape 12 can be performed easily.

Also, in the present embodiment, as well as feeder main body 13 being equipped with multiple sprocket moving units 41, because the configuration is such that the teeth of sprocket 42 of each sprocket moving unit 41 can be engaged with the sprocket holes of component supply tape 12 supplied to each tape supplier 21 and multiple tape suppliers 21 are attached to feeder main body 1 3 so that they are independently attachable and removable, there is the benefit that it is possible to change to a new component supply tape 12 by removing only the component supply tape 12 which has run out of parts together with tape supplier 21 from feeder main body 13 from among the multiple component supply tapes 12 set on feeder main body 13 which is attached to feeder loading table 66 of the electronic component mounter.

However, for the present invention, it is also acceptable for feeder main body 13 to be equipped with only 1 sprocket moving unit 41, and for the configuration to be such that only 1 tape supplier 21 is removably attached to feeder main body 13.

For the above embodiment, feeder main body 13 is equipped with reel holder 17 for storing multiple tape reels 16 together, it is also acceptable to have a configuration in which each tape supplier 21 is equipped with a reel holder for storing each tape reel 16 separately.

In addition, the present invention is not limited to the above embodiment, and it goes without saying that it is possible to have an embodiment with various changes that does not extend beyond the scope of the invention; for example, the number of tape suppliers 21 (the number of sprocket moving units 41) which can be attached to and removed from feeder main body 13 could be changed, or it would be acceptable to have a configuration in which the sprocket moving mechanism is moved up and down by sliding movement and so on.

### Symbol descriptions

11. Tape feeder; 12. Component supply tape; 13. Feeder main body; 14. Handle; 15. Operation panel; 16. Tape reel; 17. Reel holder; 21. Tape supplier; 22. Reel hook; 23. Cover tape peeling device; 24. Cover tape collection case; 25. Peeling roller; 28, 29. Cover tape indexing gear; 31. Moving device; 33. Motor; 34. Moving gear; 37, 38. Tape retainer; 41. Sprocket moving unit; 42. Sprocket; 43. Spur gear set (gear mechanism); 43a. Cog; 44. Motor; 45. Sprocket moving mechanism; 46. Bearing; 47. Elastic material; 48. Bearing retainer; 49. Screw; 51. Axis; 52. Guide pin; 53. Guide hole; 55. Spring (biasing means); 56. Motor (actuator); 57. Cam; 58. Cam contacting material; 61. Position detection dog; 62. Cam position sensor; 63. Engagement detection sensor (engagement detecting means); 64. Position detection dog; 66. Feeder loading table; 67, 68. Connector; 69, 70. Positioning pin; 71, 72. Positioning holes; 74. Guide groove; 76. Handle; 77. Positioning pin; 78. Positioning hole; 81. RF tag; 82. Reader; 84. Feeder main control device (control means); 85. Electronic component mounter control device; 86. Memory; 87. ID memorizing memory

## Claims

1. A tape feeder (11) which indexes component supply tape (12) to a component pickup position by rotating a sprocket (42) while engaging the teeth of the sprocket (42) in the sprocket holes which are formed along the edge of the component supply tape (12) in which multiple electronic components are arranged at a specific pitch, it is equipped with: a raising and lowering mechanism for moving said sprocket (42) up and down between an engagement position in which said teeth of the sprocket (42) are engaged with said sprocket holes of said component supply tape (12) and a retract position in which said teeth of the sprocket (42) are at a position lower than said sprocket holes of said component supply tape (12); and a control means (84) for controlling the operation of said raising and lowering mechanism so that said sprocket (42) is raised to said engagement position after said component supply tape (12) has been set above said sprocket (42) after said sprocket (42) has been lowered to said retract position while said component supply tape (12) is set on the tape feeder; and an engagement detection means for outputting a detection signal when said sprocket (42) has been raised to said engagement position with said teeth of the sprocket (42) engaged in said sprocket holes of said component supply tape (12) when said sprocket (42) is raised to said engagement position by said raising and lowering mechanism, the engagement detection means comprises an engagement detection sensor (63) for detecting the raising of the sprocket (42) of the sprocket moving mechanism (45) to the engagement position, wherein the sprocket teeth are engaged in sprocket holes of the component supply tape (12) when the sprocket (42) is in the engagement position.

2. The tape feeder according to claim 1 **characterized in that** said control means (84), even when no detection signal is outputted from said engagement detection sensor (63) because the teeth of said sprocket (42) are not engaged with the sprocket holes of said component supply tape (12) though controlling the raising of the sprocket (42) to the engagement position by said raising and lowering mechanism was performed, being configured to perform automatic engagement operation to rotate said sprocket (42) until the teeth of said sprocket (42) are engaged with the sprocket holes of said component supply tape (12) and said detection signal is outputted from said engagement detection sensor (63).

3. The tape feeder according to claim 1 or 2 **characterized in that** said raising and lowering mechanism is equipped with a biasing means (55) for biasing in the up direction the sprocket moving mechanism (45) with said sprocket (42) attached and an actuator (56) for opposing and lowering said sprocket moving mechanism (45) against said biasing means (55); and said control means (84) to be configured such that when said component supply tape (12) is set in the tape feeder (11), said sprocket (42) is lowered to said retract position by lowering said sprocket moving mechanism (45) against said biasing means (55) using said actuator (56) and, after said component supply tape (12) is set above said sprocket (42), said sprocket (42) is raised to said engagement position by raising said sprocket moving mechanism (45) using said biasing means (55).

4. The tape feeder according to any of claims 1 to 3 **characterized in that** said control means (84) is configured, when performing an automatic engagement operation, to rotate said sprocket (42) in the forward direction to decide the position of said component supply tape (12) after first rotating said sprocket (42) in the reverse direction, by a specific angle repeatedly until the teeth of said sprocket (42) engage with the sprocket holes in said component supply tape (12) and said detection signal is output from said engagement detection sensor (63).

5. The tape feeder according to any of claims 1 to 4 **characterized by** a configuration of a feeder main body equipped with said sprocket (42), said raising and lowering mechanism, and said control means (84); and a tape supplier (21) for supplying said component tape (12) pulled out from a tape reel (16) to said component pickup position; with said tape reel (16) and said tape supplier (21) removably attached to said feeder main body (13).

6. The tape feeder according to claim 5 **characterized by** a configuration such that said feeder main body (13) is equipped with multiple each of said sprocket (42), said raising and lower mechanism, and said engagement detection sensor (63); multiple tape suppliers (21) are independently removably attached to said feeder main body; and the teeth of each sprocket (42) can engage with the sprocket holes of the component supply tape (12) supplied to each tape supplier (21).

## Patentansprüche

1. Band-Zuführvorrichtung (11), die Bauteil-Zuführband (12) schrittweise zu einer Bauteil-Aufnahmeposition transportiert, indem sie ein Transportrad (42) dreht und dabei die Zähne des Transportrades (42) mit den Transportlöchern in Eingriff bringt, die am Rand des Bauteil-Zuführbandes (12) ausgebildet sind, in dem mehrere elektronische Bauteile in einem vorgegebenen Abstand angeordnet sind, wobei jedes mit einem Anhebe-und-Absenk-Mechanismus, mit dem das Transportrad (42) zwischen einer Eingriffs-Position, in der die Zähne des Transportrades (42) mit den Transportlöchern des Bauteil-Zuführbandes (12) in Eingriff sind, und einer eingezogenen Position nach oben und nach unten bewegt wird, in der sich die Zähne des Transportrades (42) an einer Position befinden, die tiefer liegt als die Transportlöcher des Bauteil-Zuführbandes (12), und einer Steuerungseinrichtung (84), mit der die Funktion des Anhebe-und-Absenk-Mechanismus so gesteuert wird, dass das Transportrad (42) an die Eingriffs-Position angehoben wird, nachdem das Bauteil-Zuführband (12) oberhalb des Transportrades (42) angeordnet worden ist, nachdem das Transportrad (42) an die eingezogene Position abgesenkt worden ist, während das Bauteil-Zuführband (12) an der Band-Zuführvorrichtung angeordnet ist, sowie mit einer Eingriffs-Erfassungseinrichtung versehen ist, mit der ein Erfassungs-Signal ausgegeben wird, wenn das Transportrad (42) an die Eingriffs-Position angehoben worden ist und die Zähne des Transportrades (42) mit den Transportlöchern des Bauteil-Zuführbandes (12) in Eingriff sind, wenn das Transportrad (42) durch den Anhebe-und-Absenk-Mechanismus an die Eingriffs-Position angehoben wird, wobei die Eingriffs-Erfassungseinrichtung einen Eingriffs-Erfassungssensor (63) umfasst, mit dem das Anheben des Transportrades (42) des Transportrad-Bewegungsmechanismus (45) an die Eingriffs-Position erfasst wird, und die Zähne des Transportrades mit den Transportlöchern des Bauteil-Zuführbandes (12) in Eingriff sind, wenn sich das Transportrad (42) in der Eingriffs-Position befindet.

2. Band-Zuführvorrichtung nach Anspruch 1, **dadurch gekennzeichnet, dass** die Steuerungseinrichtung (84) so eingerichtet ist, dass sie, selbst wenn von dem Eingriffs-Erfassungssensor (63) kein Erfassungs-Signal ausgegeben wird, weil die Zähne des Transportrades (42) nicht in Eingriff mit den Transportlöchern des Bauteil-Zuführbandes (12) sind, obwohl Steuern des Anhebens des Transportrades (42) an die Eingriffs-Position durch den Anhebe-und-Absenk-Mechanismus durchgeführt wurde, automatische Eingriffsbetätigung durchführt und das Transportrad (42) dreht, bis die Zähne des Transportrades (42) mit den Transportlöchern des Bauteil-Zuführbandes (12) in Eingriff sind und das Erfassungs-Signal von dem Eingriffs-Erfassungssensor (63) ausgegeben wird.

3. Band-Zuführvorrichtung nach Anspruch 1 oder 2, **dadurch gekennzeichnet, dass** der Anhebe-und-Absenk-Mechanismus mit einer Spanneinrichtung (55), mit der der Transportrad-Bewegungsmechanismus (45) mit dem angebrachten Transportrad (42) nach oben gespannt wird, sowie mit einem Betätigungselement (56) versehen ist, das entgegenwirkt und den Transportrad-Bewegungsmechanismus (45) gegen die Spanneinrichtung (55) absenkt, und die Steuerungseinrichtung (84) so eingerichtet ist, dass, wenn das Bauteil-Zuführband (12) in der Band-Zuführvorrichtung (11) angeordnet ist, das Transportrad (42) an die eingezogene Position abgesenkt wird, indem der Transportrad-Bewegungsmechanismus (45) unter Verwendung des Betätigungselementes (56) gegen die Spanneinrichtung (55) abgesenkt wird, und, nachdem das Bauteil-Zuführband (12) oberhalb des Transportrades (42) angeordnet ist, das Transportrad (42) an die Eingriffs-Position angehoben wird, indem der Transportrad-Bewegungsmechanismus (45) unter Verwendung der Spanneinrichtung (55) angehoben wird.

4. Band-Zuführvorrichtung nach einem der Ansprüche 1 bis 3, **dadurch gekennzeichnet, dass** die Steuerungseinrichtung (84) so eingerichtet ist, dass sie, wenn eine automatische Eingriffs-Betätigung durchgeführt wird, das Transportrad (42), nachdem das Transportrad (52) zunächst in der Rückwärtsrichtung gedreht wurde, um die Position des Bauteil-Zuführbandes (12) zur bestimmen, wiederholt um einen bestimmten Winkel in der Vorwärtsrichtung dreht, bis die Zähne des Transportrades (42) mit den Transportlöchern in dem Bauteil-Zuführband (12) in Eingriff kommen und das Erfassungssignal von dem Eingriffs-Erfassungssensor (63) ausgegeben wird.

5. Band-Zuführvorrichtung nach einem der Ansprüche 1 bis 4, **gekennzeichnet durch** eine Konstruktion aus einem Hauptkörper der Zuführvorrichtung, der mit dem Transportrad (42), dem Anhebe-und-Absenk-Mechanismus und der Steuerungseinrichtung (84) versehen ist, sowie einer Band-Zuführeinrichtung (21), mit der das Bauteilband, das von einer Bandspule (16) abgezogen wird, der Bauteil-Aufnahmeposition zugeführt wird, wobei die Bandspule (16) und die Band-Zuführeinrichtung (21) abnehmbar an dem Hauptkörper (13) der Zuführvorrichtung angebracht sind.

6. Band-Zuführvorrichtung nach Anspruch 5, **gekennzeichnet durch** eine Konstruktion, bei der der Hauptkörper (13) der Band-Zuführvorrichtung jeweils mit mehreren von dem Transportrad (42), dem Anhebe-und-Absenk-Mechanismus sowie dem Eingriffs-Erfassungssensor (63) versehen ist, mehrere Band-Zuführeinrichtungen (21) unabhängig abnehmbar an dem Hauptkörper der Zuführvorrichtung angebracht sind und die Zähne jedes Transportrades (42) in die Transportlöcher des jeder Band-Zuführeinrichtung (21) zugeführten Bauteil-Zuführbandes (12) eingreifen können.

## Revendications

1. Dispositif d'avancement de bande (11) qui indexe une bande de délivrance de composants (12) à une position de prélèvement de composant en faisant tourner une roue dentée (42) tout en mettant en prise les dents de la roue dentée (42) dans les trous de roue dentée qui sont formés le long de la bordure de la bande de délivrance de composants (12) sur laquelle de multiples composants électroniques sont disposés à un pas spécifique ; il est muni : d'un mécanisme d'élévation et d'abaissement destiné à déplacer ladite roue dentée (42) vers le haut et vers le bas entre une position engrenée dans laquelle lesdites dents de la roue dentée (42) sont en prise avec lesdits trous de roue dentée de ladite bande de délivrance de composants (12) et une position rétractée dans laquelle lesdites dents de la roue dentée (42) se trouvent à une position plus basse que lesdits trous de roue dentée de ladite bande de délivrance de composants (12) ; ainsi que d'un moyen de commande (84) destiné à commander le fonctionnement dudit mécanisme d'élévation et d'abaissement de sorte à ce que ladite roue dentée (42) soit relevée jusqu'à ladite position engrenée après que ladite bande de délivrance de composants (12) a été disposée au-dessus de ladite roue dentée (42) après que ladite roue dentée (42) a été abaissée jusqu'à ladite position rétractée alors que ladite bande de délivrance de composants (12) est disposée sur le dispositif d'avancement de bande ; et d'un moyen de détection d'engrènement destiné à délivrer en sortie un signal de détection au moment où ladite roue dentée (42) a été relevée jusqu'à ladite position engrenée, lesdites dents de la roue dentée (42) étant en prise dans lesdits trous de roue dentée de ladite bande de délivrance de composants (12) lorsque ladite roue dentée (42) est relevée jusqu'à ladite position engrenée par ledit mécanisme d'élévation et d'abaissement, le moyen de détection d'engrènement comprenant un capteur de détection d'engrènement (63) destiné à détecter l'élévation de la roue dentée (42) du mécanisme de déplacement de roue dentée (45) jusqu'à la position engrenée, les dents de roue dentée étant en prise dans les trous de roue dentée de la bande de délivrance de composants (12) lorsque la roue dentée (42) se trouve dans la position engrenée.

2. Dispositif d'avancement de bande selon la revendication 1, **caractérisé en ce que** ledit moyen de commande (84) est configuré pour effectuer une opération d'engrènement automatique afin de faire tourner ladite roue dentée (42) jusqu'à ce que les dents de ladite roue dentée (42) soient en prise avec les trous de roue dentée de ladite bande de délivrance de composants (12), même lorsqu'aucun signal de détection n'est délivré en sortie dudit capteur de détection d'engrènement (63) du fait que les dents de ladite roue dentée (42) ne sont pas en prise avec les trous de roue dentée de ladite bande de délivrance de composants (12) bien que la commande de l'élévation de la roue dentée (42) vers la position d'engrènement opérée par ledit mécanisme d'élévation et d'abaissement ait été effectuée, et ledit signal de détection est délivré en sortie dudit capteur de détection d'engrènement (63).

3. Dispositif d'avancement de bande selon la revendication 1 ou la revendication 2, **caractérisé en ce que** ledit mécanisme d'élévation et d'abaissement est muni d'un moyen de sollicitation (55) destiné à contraindre dans la direction vers le haut le mécanisme de déplacement de roue dentée (45), ladite roue dentée (42) étant fixée et un actionneur (56) étant destiné à opposer et à abaisser ledit mécanisme de déplacement de roue dentée (45) contre ledit moyen de sollicitation (55) ; et ledit moyen de commande (84) est configuré de sorte à ce que lorsque ladite bande de délivrance de composants (12) est disposée dans le dispositif d'avancement de bande (11), ladite roue dentée (42) est abaissée vers ladite position rétractée en abaissant ledit mécanisme de déplacement de roue dentée (45) contre ledit moyen de sollicitation (55) en utilisant ledit actionneur (56), et, après que ladite bande de délivrance de composants (12) a été disposée au-dessus de ladite roue dentée (42), ladite roue dentée (42) est relevée jusqu'à ladite position d'engrènement en relevant ledit mécanisme de déplacement de roue dentée (45) grâce à l'utilisation dudit moyen de sollicitation (55).

4. Dispositif d'avancement de bande selon l'une quelconque des revendications 1 à 3, **caractérisé en ce que** ledit moyen de commande (84) est configuré, lors de l'exécution d'une opération engrènement automatique, pour faire tourner ladite roue dentée (42) dans la direction vers l'avant afin de choisir la position de ladite bande de délivrance de composants (12) après avoir d'abord fait tourner ladite roue dentée (42) dans la direction inverse, de façon répétée d'un angle spécifique, jusqu'à ce que les dents de ladite roue dentée (42) se mettent en prise avec les trous de roue dentée dans ladite bande de délivrance de composants (12), et ledit signal de détection est délivré en sortie dudit capteur de détection d'engrènement (63).

5. Dispositif d'avancement de bande selon l'une quelconque des revendications 1 à 4, **caractérisé par** la configuration d'un corps principal de dispositif d'avancement muni de ladite roue dentée (42), dudit mécanisme d'élévation et d'abaissement et dudit moyen de commande (84) ; et par un dispositif de fourniture de bande (21) destiné à fournir ladite bande de délivrance de composants (12) retirée hors d'une bobine de bande (16) jusqu'à ladite position de prélèvement de composant ; ladite bobine de bande (16) et ledit dispositif de fourniture de bande (21) étant fixés au dit corps principal de dispositif d'avancement (13) tout en étant démontables.

6. Dispositif d'avancement de bande selon la revendication 5, **caractérisé par** une configuration telle que ledit corps principal de dispositif d'avancement (13) est muni de multiples exemplaires de ladite roue dentée (42), dudit mécanisme d'élévation et d'abaissement et dudit capteur de détection d'engrènement (63) ; de multiples dispositifs de fourniture de bande (21) sont fixés indépendamment sur ledit corps principal de dispositif d'avancement tout en étant démontables ; et les dents de chaque roue dentée (42) peuvent se mettre en prise avec les trous de roue dentée de la bande de délivrance de composants (12) fournie à chaque dispositif de fourniture de bande (21).
